# EUROPEAN PATENT APPLICATION

(11) **EP 4 685 797 A1**
(43) Date of publication of application: **28.01.2026**
(21) Application number: 25160788.3
(22) Date of filing: 28.02.2025
(51) Int. Cl.: G11C 11/16, G11C 11/56, H10N 50/10

(54) **FERROMAGNETIC MEMORY DEVICE FOR OPERATING AT MULTIPLE LEVELS, METHOD FOR MANUFACTURING THE SAME, AND SYSTEM INCLUDING THE SAME**

(30) Priority: 26.07.2024 KR 20240099679; 04.10.2024 KR 20240134488; 24.12.2024 KR 20240195398
(71) Applicant: UIF (University Industry Foundation), Yonsei University, Seoul 03722 (KR)
(72) Inventor: HONG, Jongill, 03722 Seoul (KR); JEONG, Jaegyu, 03722 Seoul (KR)
(74) Representative: Michalski Hüttermann & Partner Patentanwälte mbB

(57) **Abstract**

A ferromagnetic memory device is disclosed. The ferromagnetic memory device comprising a memory cell, wherein the memory cell includes a magnetic free layer including a magnetic layer, and wherein the magnetic free layer including a magnetic anisotropy energy gradient induced within the magnetic layer by plasma ion irradiation.

## Description

### CROSS-REFERENCE TO RELATED APPLICATION

This application claims the benefit of Korean Patent Application No. 10-2024-0099679, filed on July 26, 2023, 10-2024-0134488, filed on October 04, 2024. and 10-2024-0195398, filed on December 24, 2024 in the Korean Intellectual Property Office, the disclosure of which is incorporated herein in its entirety by reference.

### BACKGROUND

The invention relates to a ferromagnetic memory device, and more particularly, to a ferromagnetic memory device capable of operating at multiple levels by creating a magnetic anisotropy energy gradient inside a memory cell of the ferromagnetic memory device and controlling a magnetization state inside the memory cell by regions by adjusting the magnitude and pulse of an input current supplied to the ferromagnetic memory device, a method of manufacturing the ferromagnetic memory device, and a system including the ferromagnetic memory device.

The ferromagnetic memory device uses ferromagnetic material. Ferromagnetic materials are easily magnetized and maintain their magnetization states even after an external magnetic field is removed. Because of these properties, ferromagnetic memory is suitable for data storage.

The ferromagnetic memory is generally related to spintronics, which is a technology that processes information by using the spin and charge of an electron.

The ferromagnetic memory includes ferromagnetic elements, which record information according to a magnetization state so as to store data, and switching elements, which allow data to be read and written by controlling the magnetization state of ferromagnetic materials.

The ferromagnetic memory includes a magnetic tunnel junction (MTJ) formed by inserting a thin insulating layer between two ferromagnetic layers. The magnetization direction of a reference layer or pinned layer that is one of the two ferromagnetic layers may be fixed, and the magnetization direction of a magnetic free layer that is the other ferromagnetic layer may be changed.

### SUMMARY

To overcome the disadvantage of difficulty in implementing multiple levels in spin-transfer torque magnetoresistive random-access memory (STT-MRAM) that stores only one bit with a transistor and a magnetic tunnel junction (MTJ), the inventive concept provides a ferromagnetic memory device capable of operating at multiple levels by creating a magnetic anisotropy energy gradient inside a memory cell of the ferromagnetic memory device and controlling a magnetization state inside the memory cell by regions by adjusting the magnitude and pulse of an input current supplied to the ferromagnetic memory device, a method of manufacturing the ferromagnetic memory device, and a system including the ferromagnetic memory device.

According to embodiments of the invention, there is provided a ferromagnetic memory device including a memory cell, wherein the memory cell includes a magnetic free layer including a magnetic layer, and the magnetic free layer including a magnetic anisotropy energy gradient induced within the magnetic layer by plasma ion irradiation.

The magnetic layer includes a plurality of magnetic domains formed according to the magnetic anisotropy energy gradient induced by the plasma ion irradiation, and the magnetic anisotropy energy gradient is induced by a magnetization state of each of the plurality of magnetic domains and a magnetization state formed by physical defects including a vacancy and non-uniformity of a chemical state formed inside the each of the plurality of magnetic domains during the plasma ion irradiation.

According to embodiments of the invention, there is provided a semiconductor device including a ferromagnetic memory device, the ferromagnetic memory device includes a memory cell including a plurality of magnetic domains generated in a magnetic free layer, and a magnetic anisotropy energy gradient is induced in the magnetic free layer when ions are injected into the magnetic free layer, and the magnetic domains are formed according to the induced magnetic anisotropy energy gradient.

According to embodiments of the invention, there is provided a method of manufacturing a ferromagnetic memory device. The method includes providing a memory device having a memory cell including a magnetic free layer having a magnetic layer and forming a magnetic anisotropy energy gradient within the memory cell.

According to embodiments of the invention, there is provided a method of manufacturing a ferromagnetic memory device. The method includes positioning a first mask pattern on a memory device having a memory cell including a magnetic free layer including a magnetic material and forming a magnetic anisotropy energy gradient within the memory cell by changing a first region of the magnetic layer into a first magnetic domain by changing magnetic anisotropy energy of the first region of the magnetic layer by irradiating first ions accelerated by a first acceleration voltage to the first region of the magnetic layer through the first mask pattern.

### BRIEF DESCRIPTION OF THE DRAWINGS

Embodiments of the inventive concept will be more clearly understood from the following detailed description taken in conjunction with the accompanying drawings in which:
FIG. 1 is a schematic diagram of a semiconductor system including a ferromagnetic memory device having a memory cell including a magnetic layer having a magnetic anisotropy energy gradient, according to an embodiment of the invention;
FIG. 2 is a schematic diagram of the ferromagnetic memory device in FIG. 1, taken along line A-A;
FIG. 3 is an enlarged view of the memory cell of the ferromagnetic memory device in FIG. 1;
FIG. 4 is a schematic diagram of various magnetic hysteresis loops showing the magnitude of magnetization versus the intensity of the magnetic field of a ferromagnetic material under various conditions;
FIG. 5 are an enlarged view of the memory cell in FIG. 1 before the magnetic anisotropy energy gradient is formed in the memory cell and a schematic cross-sectional view of the memory cell taken along line B-B;
FIG. 6 is a schematic diagram illustrating a method of generating a first magnetic domain by irradiating ions accelerated by a first acceleration voltage to a first region of a memory cell region in (A) of FIG. 5 through a first mask pattern;
FIG. 7 is a schematic diagram illustrating a method of generating a second magnetic domain by irradiating ions accelerated by a second acceleration voltage to a second region of the memory cell region in (A) of FIG. 5 through a second mask pattern;
FIG. 8 is a schematic diagram illustrating a method of generating a third magnetic domain by irradiating ions accelerated by a third acceleration voltage to a third region of the memory cell region in (A) of FIG. 5 through a third mask pattern;
FIG. 9 is a conceptual diagram illustrating a method of controlling the magnetization direction of each of the first to third magnetic domains, which are respectively generated according to FIGS. 6 to 8, according to the number of toggling times of an input current;
FIG. 10A is a schematic graph of Hall resistance gradually changing according to the number of toggling times of an input pulse current in FIG. 9;
FIG. 10B is a conceptual diagram illustrating a magnetization state changing according to the number of toggling times of an input pulse current supplied to the ferromagnetic memory device in FIG. 1;
FIG. 11 is a conceptual diagram illustrating a method of controlling the magnetization direction of each of the first to third magnetic domains, which are respectively generated according to FIGS. 6 to 8, according to the pulse width of an input current;
FIG. 12 is a schematic graph illustrating the relationship between the change in the pulse width of an input current and the change of Hall resistance when the input current is a first-direction input current;
FIG. 13 is a schematic graph illustrating the relationship between the change in the pulse width of an input current and the change of Hall resistance when the input current is a second-direction input current;
FIG. 14 is a conceptual diagram illustrating a method of controlling the magnetization direction of each of the first to third magnetic domains, which are respectively generated according to FIGS. 6 to 8, according to the variation of the amplitude of an input current;
FIG. 15 is a schematic graph illustrating the relationship between the variation of the amplitude of an input current and the change of Hall resistance when the pulse width of the input current is fixed, according to an embodiment of the inventive concept;
FIG. 16 is a schematic graph illustrating the relationship between the variation of the amplitude of an input current and the change of Hall resistance when the pulse width of the input current is fixed, according to some embodiments of the inventive concept;
FIG. 17 is a flowchart of a method of manufacturing the ferromagnetic memory device having a magnetic anisotropy energy gradient in FIG. 1 and a method of controlling the movement of magnetization states or magnetic domains of the ferromagnetic memory device by using an input current; and
FIG. 18 is a schematic diagram of a process-in-memory including the ferromagnetic memory device having a magnetic anisotropy energy gradient in FIG. 1.

### DETAILED DESCRIPTION OF THE EMBODIMENTS

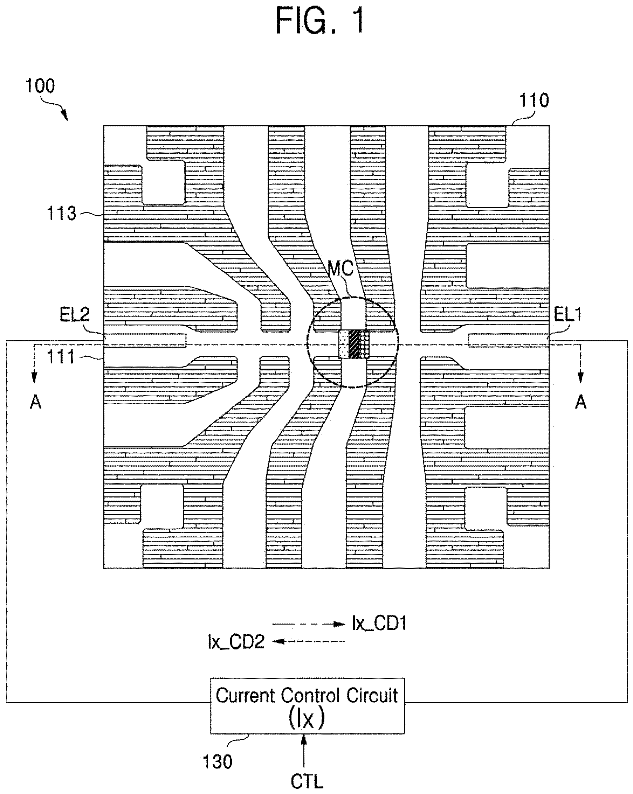

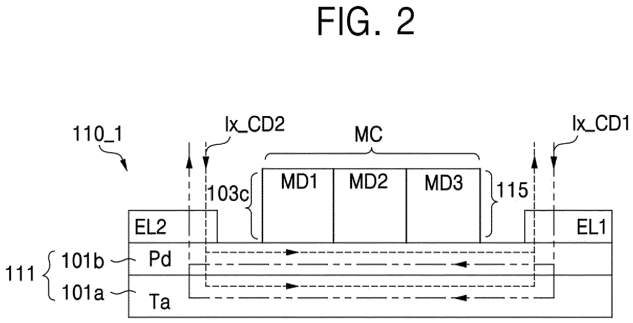

FIG. 1 is a schematic diagram of a semiconductor system including a ferromagnetic memory device having a memory cell including a magnetic layer having a magnetic anisotropy energy gradient, according to an embodiment of the invention. FIG. 2 is a schematic diagram of the ferromagnetic memory device in FIG. 1, taken along line A-A.

A semiconductor system 100 of FIG. 1 may include a ferromagnetic memory device 110 and an input current control circuit 130.

The semiconductor system 100 may refer to a semiconductor device, a semiconductor integrated circuit, a system-on-chip (SoC), a process-in-memory (PIM), a computing-in-memory (CIM), or a processor.

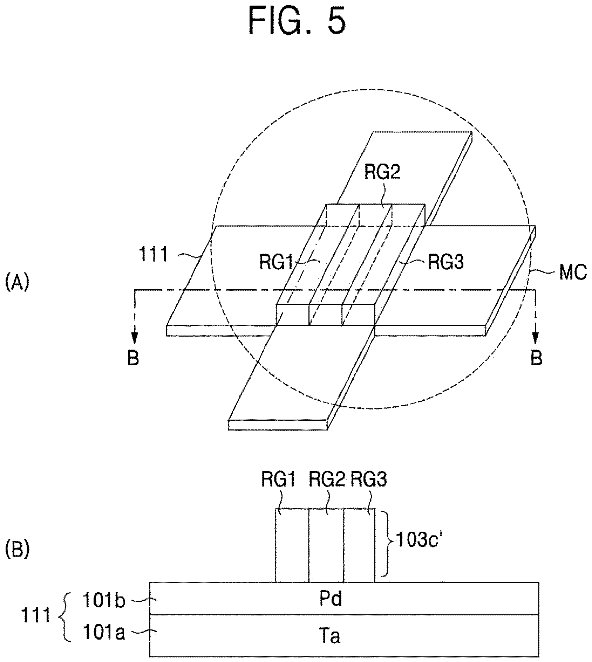

According to an embodiment of the invention, the ferromagnetic memory device 110 may refer to a device which stores data of at least 2 bits by using the properties of a ferromagnetic material. The ferromagnetic memory device 110 may have a magnetic anisotropy energy gradient formed inside a memory cell MC by reducing a magnetic material of each of regions RG1, RG2, and RG3, which is included in a magnetic layer (referred to as a first magnetic layer, 103c') of the memory cell MC shown in (A) of FIG. 5, through plasma ion irradiation.

For example, the first magnetic layer 103c' may include a magnetic material. The magnetic material may include at least one of a ferromagnetic material, a paramagnetic material, or an anti-ferromagnetic material. According to embodiments, a magnetic material included in the first magnetic layer 103c' may include (i) a paramagnetic material or (ii) both a paramagnetic material and a ferromagnetic material, but the invention is not limited thereto.

As ions accelerated by different acceleration voltages are irradiated or injected into the memory cell MC, for example each of regions RG1 to RG3 at different time points, respectively, the magnetic anisotropy energy of the memory cell MC may be formed differently, and accordingly, a magnetic anisotropy energy gradient may be formed inside the memory cell MC. As the magnetic anisotropy energy gradient is formed, magnetic domains may be generated.

Referring to FIGs. 1 and 2, the ferromagnetic memory device 110 may include a memory cell MC. The memory cell MC may include a electric conductive layer 111 having current electrodes EL1 and EL2 and a magnetic free layer 115. The input current or input voltage is supplied to electric conductive layer 111.

The electric conductive layer 111 is a layer that conducts electricity well and may include at least one of a palladium (Pd), a tantalum (Ta), a gold (Au), a copper (Cu), or aluminum (Al). The magnetic free layer 115 may include at least one of a palladium (Pd), a tantalum (Ta), a gold (Au), a copper (Cu), or aluminum (Al), but the invention is not limited thereto.

The magnetic free layer 115 may include a plurality of magnetic domains MD1, MD2, and MD3 formed according to a magnetic anisotropy energy gradient or a plurality of patterns MD1, MD2, and MD3 having different magnetization states. For example, each of the magnetic domains MD1, MD2, and MD3 formed in a magnetic layer (referred to as a second magnetic layer, 103c) included in the magnetic free layer 115 may refer to a ferromagnetic region (or ferromagnetic materials). For example, reference numeral 113 may denote a portion etched by an etching process, the etched portion may be filled with materials, for example insulating materials. The magnetic free layer 115 may be identical to the second magnetic layer 103c or may include the second magnetic layer 103c.

The magnetic anisotropy energy gradient is a concept in which the magnitude of energy in a magnetic material varies depending on the magnetization direction, and this change in magnitude appears according to the physical direction. In magnetic materials, magnetic anisotropy refers to a phenomenon in which the properties of a material changes depending on a magnetization direction, and magnetic anisotropy energy explains how magnetic energy changes depending on a magnetization direction.

Referring to a cross-section 110_1 taken along line A-A of FIG. 2, the memory cell MC including the magnetic free layer 115 may include a tantalum (Ta) layer 101a, a palladium (Pd) layer 101b formed on the Ta layer 101a, and a second magnetic layer 103c formed on the Pd layer 101b. The second magnetic layer 103c may include magnetic domains MD1, MD2, and MD3. According to embodiments, the positions of the Ta layer 101a and the Pd layer 101b may be swapped.

For example, the Pd layer 101b within the memory cell MC may absorb and store hydrogens or hydrogen ions, which is generated in each of the magnetic domains MD1, MD2, and MD3 by hydrogen ion irradiation or injection.

The second magnetic layer 103c included in the magnetic free layer 115 may include ferromagnetic regions MD1, MD2, and MD3 related to a magnetic anisotropy energy gradient.

For example, the second magnetic layer 103c may include magnetic materials. The magnetic materials may include at least one of a ferromagnetic material, a paramagnetic material, or an anti-ferromagnetic material. According to embodiments, magnetic materials included in the second magnetic layer 103c may include (i) a paramagnetic material or (ii) both a paramagnetic material and a ferromagnetic material, but the invention is not limited thereto.

The magnetic domains MD1, MD2, and MD3 generated as a magnetic anisotropy energy gradient is formed will be described in detail with reference to FIGS. 5 to 8.

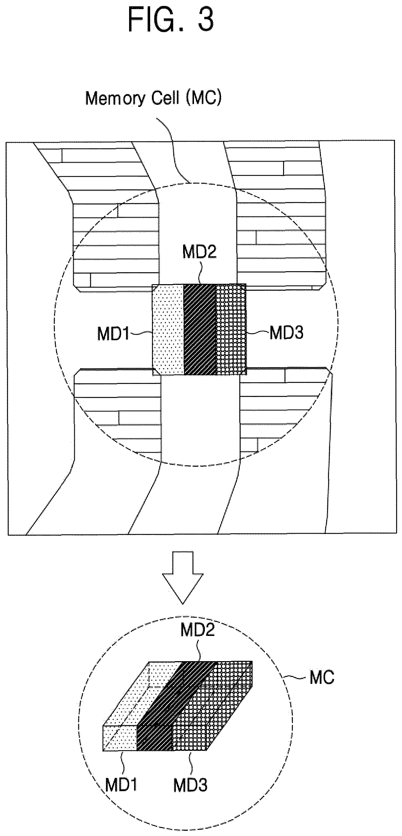

To describe that the magnetic domains MD1, MD2, and MD3 are formed as a magnetic anisotropy energy gradient is formed inside the memory cell MC, the magnetic domains MD1, MD2, and MD3 formed in the ferromagnetic memory device 110 are illustrated in a plan view of the memory cell MC of the ferromagnetic memory device 110 in FIGS. 1 and 3.

Referring to FIG. 2, it may be assumed that the thickness of the Ta layer 101a within the memory cell MC is 4 nm, the thickness of the Pd layer 101b is 3 nm, the thickness of the second magnetic layer 103c in which the magnetic domains MD1, MD2, and MD3 are formed is 0.7 nm, but the invention is not limited thereto.

The input current control circuit 130 may generate an input current (referred to as an input pulse current) Ix, which has a variable characteristic, according to a current control signal CTL and may transmit the input current Ix to a current electrode EL1 or EL2.

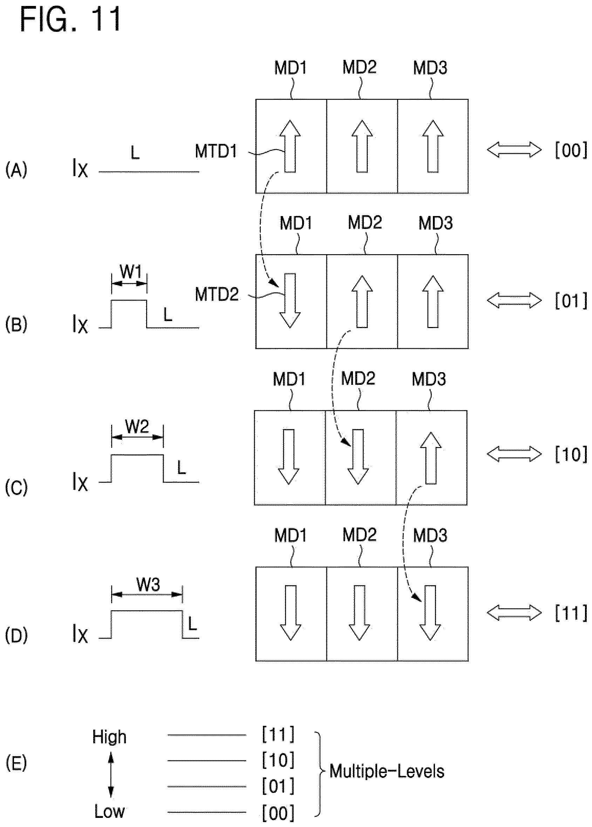

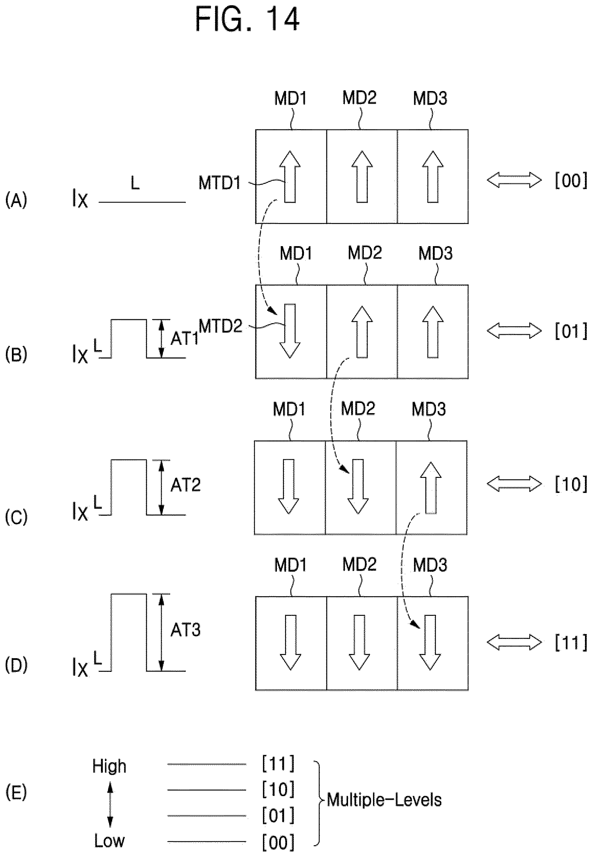

Here, the variable characteristic of the input current Ix may include the number of pulses (or toggling times) in the input current Ix, the pulse width of the input current Ix, which will be described with reference to FIG. 11, or the amplitude of the input current Ix, which will be described with reference to FIG. 14.

The input current control circuit 130 may also control the direction of the input current Ix according to the current control signal CTL. As shown in FIGS. 1 and 2, the input current Ix flowing from a first current electrode EL1 to a second current electrode EL2 is referred to as a first-direction input current Ix_CD1, and the input current Ix flowing from the second current electrode EL2 to the first current electrode EL1 is referred to as a second-direction input current Ix_CD2.

Referring to FIG. 2, each of the first and second current electrodes EL1 and EL2 may be formed of a conductive metal, such as titanium (Ti), gold (Au), copper (Cu), or aluminum (Al) through deposition to measure a current flowing in the ferromagnetic memory device 110 or supply the current to the ferromagnetic memory device 110. The deposition may include physical vapor deposition (PVD) or chemical vapor deposition (CVD).

The first-direction input current Ix_CD1 input to the first current electrode EL1 or the second-direction input current Ix_CD2 input to the second current electrode EL2 may flow through a electric conductive layer 111 to form a current path, as shown in FIG. 2.

FIG. 3 is an enlarged view of the memory cell of the ferromagnetic memory device 110 in FIG. 1. Referring to FIGS. 1 to 3, the second magnetic layer 103c of the memory cell MC may include "n" magnetic domains (e.g., MD1, MD2, and MD3) formed as a magnetic anisotropy energy gradient is formed. Here, "n" is 1 or a natural number greater than 1.

For convenience of description, a case where "n" is 3 is described as an example. However, one or more magnetic domains may be formed according to a magnetic anisotropy energy gradient or the non-uniformity of the chemical state and physical defects such as vacancies formed in the second magnetic layer 103c in order to implement multiple levels.

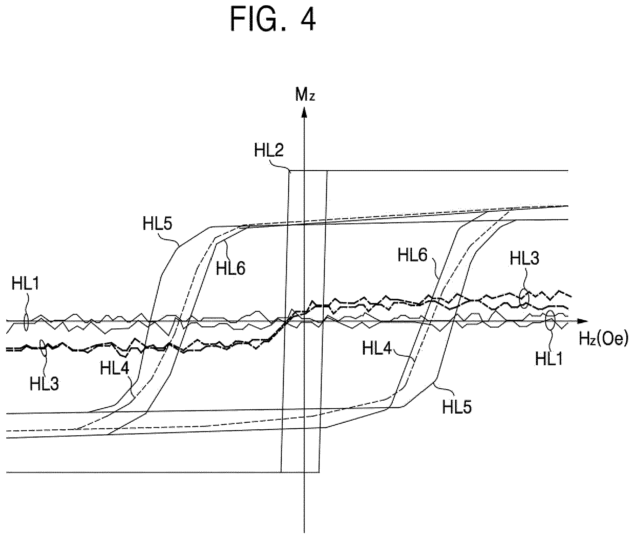

FIG. 4 is a schematic diagram of various magnetic hysteresis loops showing the magnitude of magnetization versus the intensity of the magnetic field of a ferromagnetic material under various conditions. FIG. 5 are an enlarged view of the memory cell in FIG. 1 before the magnetic anisotropy energy gradient is formed in the memory cell and a schematic cross-sectional view of the memory cell taken along line B-B. In FIG. 4, the x-axis represents the intensity of the magnetic field (for example, an external magnetic field) and the unit of the intensity of the magnetic field is oersted (Oe), and y-axis represents the magnitude (Mz) of magnetization.

In FIG. 4, HL1 denotes a magnetic hysteresis loop of the magnitude (Mz) of magnetization with respect to the intensity (Hz) of a magnetic field before a first magnetic layer 103c' including regions RG1, RG2, and RG3 in (B) of FIG. 5 is converted into the second magnetic layer 103c including magnetic domains MD1, MD2, and MD3 in FIG. 2 by the irradiation of ions (e.g., irradiation of hydrogen ions).

(A) of FIG. 5 is a plan view before a magnetic anisotropy energy gradient is formed in the memory cell MC, and (B) of FIG. 5 is a cross-sectional view of the memory cell MC taken along line B-B in (A) of FIG. 5.

To describe a stage before a magnetic anisotropy energy gradient is formed inside the memory cell MC, a plurality of regions RG1, RG2, and RG3 are illustrated in the plan view of the memory cell MC in (A) of FIG. 5.

Here, each of the regions RG1, RG2, and RG3 may refer to a region of the memory cell MC, an internal region included in the first magnetic layer 103c', or an internal region of the first magnetic layer 103c' that matches the surface region of the memory cell MC.

Referring to (A) and (B) of FIG. 5, the memory cell MC may include the magnetic free layer 115 (for example, the magnetic free layer 115 includes the first magnetic layer 103c' formed regions RG1, RG2, and RG3) including first magnetic layer 103c' without magnetism, e.g., cobalt oxide (Co₃O₄) layer. As described above, the first magnetic layer 103c' may include a mixture of a paramagnetic material and a ferromagnetic material, but embodiments are not limited thereto.

In FIG. 4, HL2 denotes a magnetic hysteresis loop of the magnitude (Mz) of magnetization with respect to the intensity (Hz) of a magnetic field when the first magnetic layer 103c' in (B) of FIG. 5 is a cobalt layer. In other words, HL2 may denote a reference magnetic hysteresis loop for comparison with other magnetic hysteresis loops HL3 to HL6.

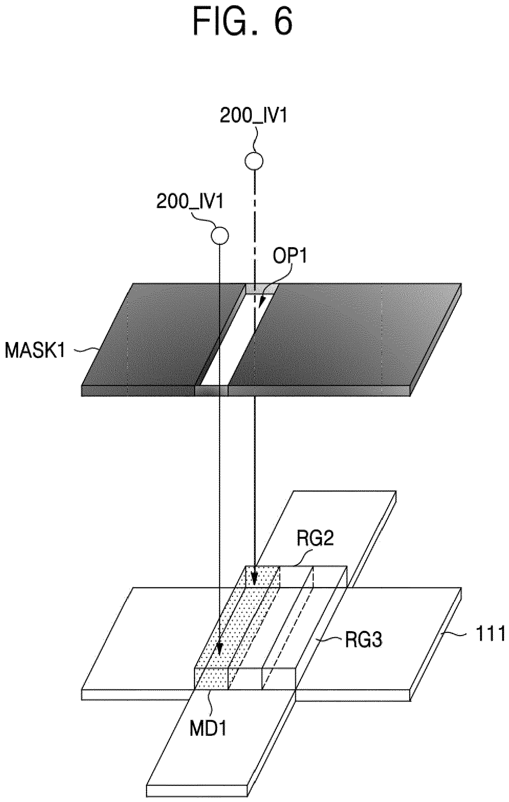

FIG. 6 is a schematic diagram illustrating a method of generating a first magnetic domain by irradiating ions accelerated by a first acceleration voltage to a first region of a memory cell region in (A) of FIG. 5 through a first mask pattern.

Referring to FIGS. 4 to 6, the magnetic hysteresis loop HL3 in FIG. 4 shows the magnitude (Mz) of magnetization with respect to the intensity (Hz) of a magnetic field when a first region RG1 of the memory cell MC (or the first magnetic layer 103c') is converted into a first magnetic domain MD1 as first ions 200_IV1 accelerated by a first acceleration voltage (IV1, e.g., 100 V) are irradiated to the first region RG1 through a first opening OP1 of a first mask pattern MASK1.

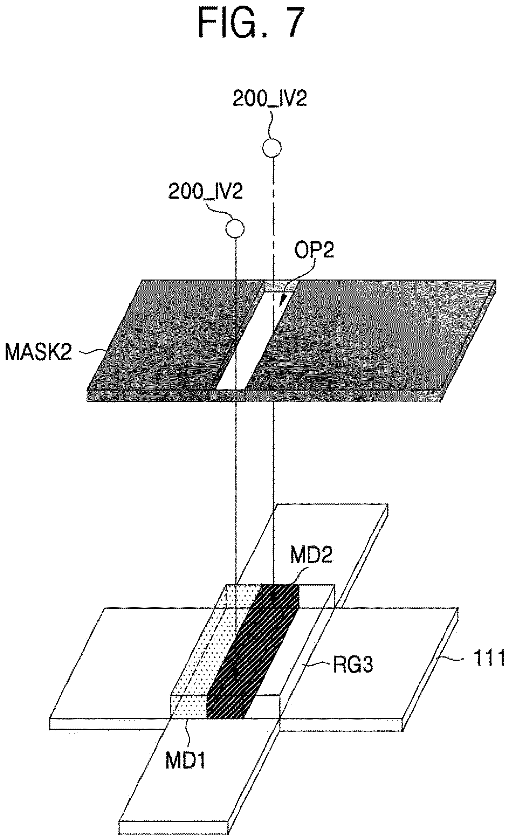

FIG. 7 is a schematic diagram illustrating a method of generating a second magnetic domain by irradiating ions accelerated by a second acceleration voltage to a second region of the memory cell region in (A) of FIG. 5 through a second mask pattern.

Referring to FIGS. 4 and 7, the magnetic hysteresis loop HL6 in FIG. 4 shows the magnitude (Mz) of magnetization with respect to the intensity (Hz) of the magnetic field of a second region RG2 of the memory cell MC (or the first magnetic layer 103c') when the second region RG2 is converted into a second magnetic domain MD2 as second ions 200_IV2 accelerated by a second acceleration voltage (IV2, e.g., 500 V) are irradiated to the second region RG2 through a second opening OP2 of a second mask pattern MASK2.

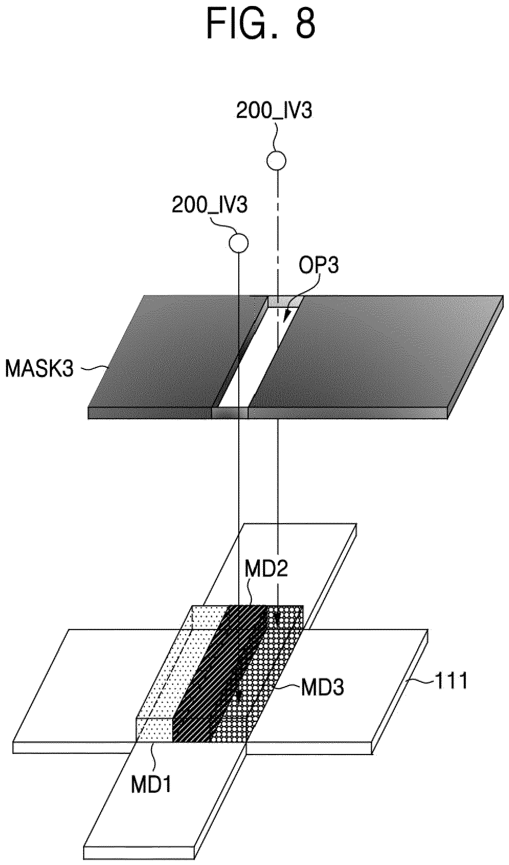

FIG. 8 is a schematic diagram illustrating a method of generating a third magnetic domain by irradiating ions accelerated by a third acceleration voltage to a third region of the memory cell region in (A) of FIG. 5 through a third mask pattern.

Referring to FIGS. 4 and 8, the magnetic hysteresis loop HL4 in FIG. 4 shows the magnitude (Mz) of magnetization with respect to the intensity (Hz) of the magnetic field of a third region RG3 of the memory cell MC (or the first magnetic layer 103c') when the third region RG3 is converted into a third magnetic domain MD3 as third ions 200_IV3 accelerated by a third acceleration voltage (IV3, e.g., 200 V) are irradiated to the third region RG3 through a third opening OP3 of a third mask pattern MASK3.

The first to third ions 200_IV1, 200_IV2, and 200_IV3 may be the same kind of ions (e.g., hydrogen ions).

Referring to FIGS. 4 to 8, the magnetic hysteresis loop HL5 in FIG. 4 shows the magnitude (Mz) of magnetization with respect to the intensity (Hz) of a magnetic field when one of regions RG1, RG2, or RG3 of the memory cell MC is converted into one of the magnetic domains MD1, MD2, and MD3 as fourth ions accelerated by a fourth acceleration voltage (e.g., 300 V) are irradiated to one region of the memory cell MC through the first opening OP1 of the first mask pattern MASK1, the second opening OP2 of the second mask pattern MASK2, or the third opening OP3 of the third mask pattern MASK3.

In other words, each of the regions RG1, RG2, and RG3 may be converted into a magnetic domain MD1, MD2, or MD3 according to ions irradiated thereto.

Referring to each of the magnetic hysteresis loops HL1 to HL6 in FIG. 4, when acceleration energy (or acceleration voltage) of ions irradiated to each region RG1, RG2, or RG3 is changed according to an ion irradiation method, different magnetic characteristics and/or different magnetic anisotropy energy gradients may be induced for the magnetic domains MD1, MD2, and MD3 respectively corresponding to the regions RG1, RG2, and RG3, so that a magnetic pattern may be implemented in each of the magnetic domains MD1, MD2, and MD3.

For example, a magnetic anisotropy energy gradient may be induced not only by the magnetization states of the magnetic domains MD1, MD2, and MD3 but also by a magnetization state formed by physical defects, such as vacancies, and the non-uniformity of a chemical state formed in the magnetic domains MD1, MD2, and MD3 during ion irradiation.

The non-uniformity of a chemical state may locally occur due to a difference in chemical concentration (or density) or composition in each of the magnetic domains MD1, MD2, and MD3 and may also occur because compounds or specific substances, which may be formed in each of the magnetic domains MD1, MD2, and MD3 due to ion irradiation, gather too much or escape too much due to defects.

When the concentration of a specific substance increases or decreases or a physical defect occurs within each of the magnetic domains MD1, MD2, and MD3, the magnetic properties of each of the magnetic domains MD1, MD2, and MD3 may change.

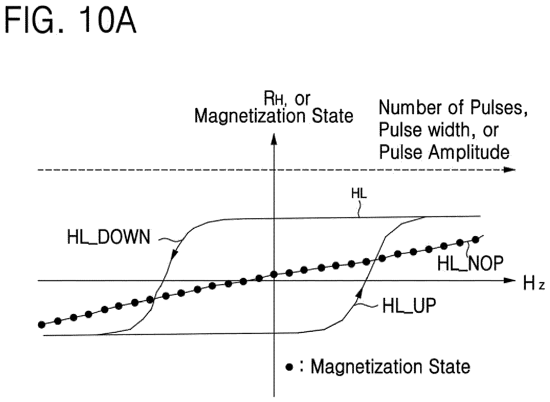

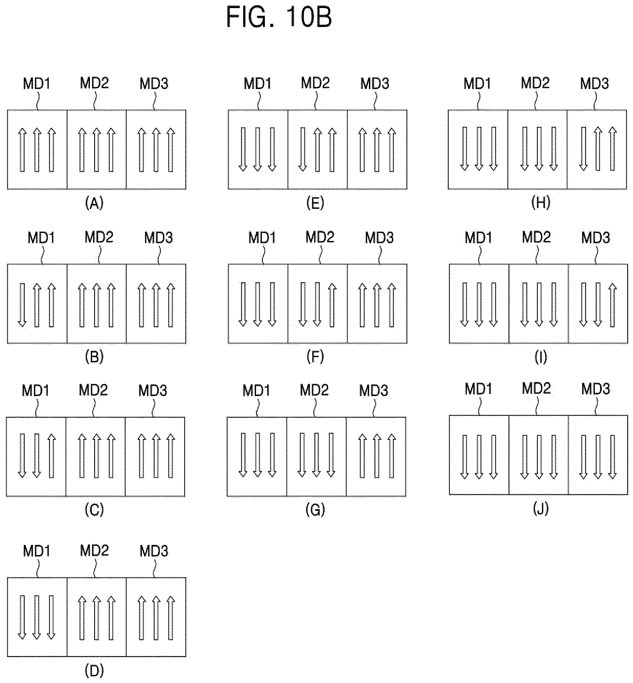

Because chemical non-uniformity and physical defects may enhance or weaken anisotropy in each of the magnetic domains MD1, MD2, and MD3, the domain wall of each of the magnetic domains MD1, MD2, and MD3 may move several times instead of all at once within each of the magnetic domains MD1, MD2, and MD3. This stepwise movement may correspond to a phenomenon in which Hall resistance gradually changes, which will be described below with reference to FIGS. 10A and 10B.

For example, hydrogen ions may collide with oxygen atoms or oxygen ions of a magnetic material, e.g., cobalt oxide, included in each of the regions RG1, RG2, and RG3 and thus convert each of the regions RG1, RG2, and RG3 into one of the magnetic domains MD1, MD2, and MD3. Although cobalt oxide may have various compositions in the form of CoₓO₁₋ₓ, such as Co₃O₄ or CoO, the cobalt oxide becomes cobalt (Co) regardless of its composition when it is reduced.

For example, when cobalt oxide (Co₃O₄) is reduced by a hydrogen ion (H⁺), cobalt oxide (Co₃O₄) becomes cobalt (Co). As the oxidation state changes during the reduction, oxygen is removed from cobalt oxide (Co₃O₄), so that cobalt (Co) may be formed.

For example, cobalt oxide (Co₃O₄) is a mixed oxide in which cobalt simultaneously has a +2 oxidation state and a +3 oxidation state. When the cobalt oxide (Co₃O₄) is reduced, cobalt changes into a metallic state with oxidation number 0.

An example of the reduction reaction of cobalt oxide (Co₃O₄) is shown in Chemical formula 1:

Co₃O₄ + 8H⁺ + 8e⁻ → 3Co + 4H₂O.

When each of the regions RG1, RG2, and RG3 includes a paramagnetic material (e.g., cobalt oxide (Co₃O₄)), hydrogen ions irradiated (or injected) into each region RG1, RG2, or RG3 may convert the region RG1, RG2, or RG3 into a magnetic domain MD1, MD2, or MD3 by reducing the paramagnetic material (e.g., cobalt oxide (Co₃O₄)) included in the region RG1, RG2, or RG3 via a mechanism, such as Chemical formula 1, but the inventive concept is not limited thereto.

According to some embodiments, when each of the regions RG1, RG2, and RG3 includes both a paramagnetic material (e.g., cobalt oxide (Co₃O₄)) and a ferromagnetic material, hydrogen ions irradiated (or injected) into each region RG1, RG2, or RG3 may convert the region RG1, RG2, or RG3 into a magnetic domain MD1, MD2, or MD3 by reducing the paramagnetic material (e.g., cobalt oxide (Co₃O₄)) included in the region RG1, RG2, or RG3 via a mechanism, such as Chemical formula 1, but the inventive concept is not limited thereto.

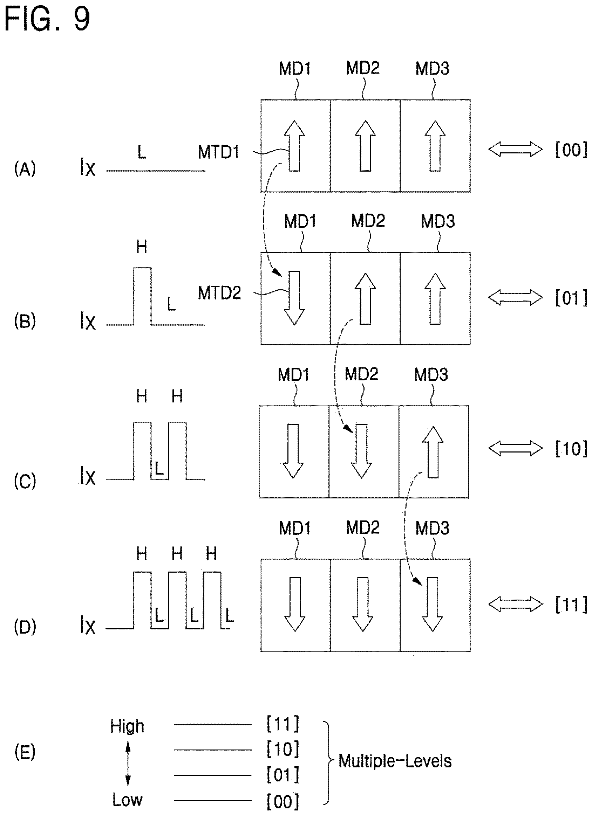

FIG. 9 is a conceptual diagram illustrating a method of controlling the magnetization direction of each of the first to third magnetic domains, which are respectively generated according to FIGS. 6 to 8, according to the number of toggling times of an input current.

Referring to FIG. 1 and FIGS. 6 to 9, the input current control circuit 130 may control the number of pulses in the first-direction input current Ix_CD1 or the second-direction input current Ix_CD2 in response to the current control signal CTL. For convenience of description, the first-direction input current Ix_CD1 and the second-direction input current Ix_CD2 are collectively referred to as the input current Ix.

Referring to (A) of FIG. 9, when the input current control circuit 130 supplies the input current Ix at a low-level L to the ferromagnetic memory device 110 in response to the current control signal CTL, the magnetization direction of each of the magnetic domains MD1, MD2, and MD3 may be a first magnetization direction MTD1.

It is assumed that when the magnetization direction of each of the magnetic domains MD1, MD2, and MD3 is the first magnetization direction MTD1, the memory cell MC of the ferromagnetic memory device 110 indicates or stores a first level [00] among multiple levels. For convenience of description, assuming that the multiple levels include four levels, the first level [00] may be defined or interpreted as 2b'00 among 2-bit data in a read operation. Here, a level may refer to a method of representing a signal, information, or data.

Referring to (A) and (B) of FIG. 9, when the input current control circuit 130 supplies the input current Ix, which has a single pulse or toggles once, to the ferromagnetic memory device 110 in response to the current control signal CTL, the magnetization direction of only the first magnetic domain MD1 among the first to third magnetic domains MD1, MD2, and MD3 may be changed from the first magnetization direction MTD1 into a second magnetization direction MTD2, and the other magnetic domains, i.e., the second and third magnetic domains MD2 and MD3, may maintain the first magnetization direction MTD1.

In this case, assuming that the memory cell MC of the ferromagnetic memory device 110 indicates or stores a second level [01] among the four levels, the second level [01] may be defined or interpreted as 2b'01 among the 2-bit data in a read operation.

Referring to (B) and (C) of FIG. 9, when the input current control circuit 130 supplies the input current Ix, which has two pulses or toggles twice, to the ferromagnetic memory device 110 in response to the current control signal CTL, the magnetization direction of only the second magnetic domain MD2 among the first to third magnetic domains MD1, MD2, and MD3 may be changed from the first magnetization direction MTD1 into the second magnetization direction MTD2, and the first and third magnetic domains MD1 and MD3, may respectively maintain the second magnetization direction MTD2 and the first magnetization direction MTD1.

In this case, assuming that the memory cell MC of the ferromagnetic memory device 110 indicates or stores a third level [10] among the four levels, the third level [10] may be defined or interpreted as 2b'10 among the 2-bit data in a read operation.

Referring to (C) and (D) of FIG. 9, when the input current control circuit 130 supplies the input current Ix, which has three pulses or toggles three times, to the ferromagnetic memory device 110 in response to the current control signal CTL, the magnetization direction of only the third magnetic domain MD3 among the first to third magnetic domains MD1, MD2, and MD3 may be changed from the first magnetization direction MTD1 into the second magnetization direction MTD2, and the first and second magnetic domains MD1 and MD2 may maintain the second magnetization direction MTD2.

In this case, assuming that the memory cell MC of the ferromagnetic memory device 110 indicates or stores a fourth level [11] among the four levels, the fourth level [11] may be defined or interpreted as 2b'11 among the 2-bit data in a read operation.

Referring to (E) of FIG. 9, the second level [01] may be higher than the first level [00], the third level [10] may be higher than the second level [01], and the fourth level [11] may be higher than the third level [10].

Although FIG. 9 illustrates an embodiment in which the level increases as the number of pulses in one of the first-direction input current Ix_CD1 and the second-direction input current Ix_CD2 increases, the level may decrease as the number of pulses in the other one of the first-direction input current Ix_CD1 and the second-direction input current Ix_CD2 increases.

According to embodiments, the magnetization directions of two magnetic domains (e.g., MD1 and MD2, MD2 and MD3, or MD1 and MD3) among the first to third magnetic domains MD1, MD2, and MD3 may be simultaneously switched between the first magnetization direction MTD1 and the second magnetization direction MTD2 according to the change in the number of pulses in the input current Ix.

According to embodiments, the magnetization directions of the first to third magnetic domains MD1, MD2, and MD3 may be simultaneously switched between the first magnetization direction MTD1 and the second magnetization direction MTD2 according to the change in the number of pulses in the input current Ix.

The magnetization direction of which of the first to third magnetic domains MD1, MD2, and MD3 is to be changed first or the magnetization directions of how many of the first to third magnetic domains MD1, MD2, and MD3 are to be changed simultaneously may be variously changed according to embodiments by using the number of pulses in the input current Ix that may vary.

FIG. 10A is a schematic graph of Hall resistance gradually changing according to the number of toggling times of an input pulse current in FIG. 9.

Referring to FIGS. 9 and 10A, HL denotes a magnetic hysteresis loop of the magnitude (Mz) of magnetization with respect to the intensity (Hz) of a magnetic field, and HL_NOP is a schematic graph showing Hall resistance R_{H} increasing gradually or in an analog fashion as the number of pulses in the input current Ix increases.

This may indicate that as the number of pulses in the input current Ix changes, magnetization (or a magnetization state) does not change according to the magnetic domains MD1, MD2, and MD3 but gradually or stepwise changes within each region RG1, RG2, or RG3.

This change may be caused by a magnetic anisotropy energy gradient formed by a magnetization state, which is influenced not only by the magnetic domains MD1, MD2, and MD3 but also by physical defects, such as vacancies, and the non-uniformity of a chemical state formed in the magnetic domains MD1, MD2, and MD3 during ion irradiation.

As shown in FIG. 10A, a large number of different magnetization states corresponding to an analog signal may be induced. In other words, the number of magnetic domains may be different from the number of magnetization states. In FIG. 10A, the dots are examples of magnetization states illustrated for convenience of description.

HL_UP may denote a portion of the magnetic hysteresis loop HL, which changes according to the first-direction input current Ix_CD1, and HL_DOWN may denote a portion of the magnetic hysteresis loop HL, which changes according to the second-direction input current Ix_CD2.

Accordingly, when the input current Ix to the ferromagnetic memory device 110 is appropriately controlled, various fine multiple levels may be implemented in an analog fashion in the ferromagnetic memory device 110.

FIG. 10B is a conceptual diagram illustrating a magnetization state changing according to the number of toggling times of an input pulse current supplied to the ferromagnetic memory device in FIG. 1.

Referring to FIGS. 10A and 10B, a magnetic domain may move when the input pulse current Ix changes, and a plurality of magnetization states may be generated or determined in the memory cell MC.

For example, a magnetization state may be determined according to a magnetization direction and a magnetization magnitude.

A magnetization direction refers to an alignment direction of magnetic particles in an object. A magnetization direction may be determined when the spins of magnetic atoms or molecules in a magnetized material are aligned with a certain direction. A magnetization magnitude represents the magnitude of a magnetic moment possessed by a magnetized material. A net magnetic moment possessed by magnetic particles per unit volume in an object corresponds to a magnetization magnitude.

Here, a magnetization direction and a magnetization magnitude may be determined according to the number of toggling times of a current pulse, the width of the current pulse, or the amplitude of the current pulse.

Although the magnetization state is indicated by three magnetization directions are shown in each of the first to third magnetic domains MD1, MD2, and MD3 in FIG. 10B for convenience of description of the magnetization state within each domain, embodiments are not limited thereto. The magnetization state is indicated by two magnetization directions or four or more magnetization directions may be shown in each of the first to third magnetic domains MD1, MD2, and MD3. When the input pulse current Ix changes, for example, when the number of toggling times increases, a magnetic domain may move, and a magnetization state may change.

For example, when the number of toggling times of the input pulse current Ix increases, the magnetization state of the first magnetic domain MD1 may sequentially change from (A) of FIG. 10B to (D) of FIG. 10B. When the number of toggling times of the input pulse current Ix increases further, the magnetization state of the second magnetic domain MD2 may sequentially change from (E) to (G) of FIG. 10B. When the number of toggling times of the input pulse current Ix increases further, the magnetization state of the third magnetic domain MD3 may sequentially change from (H) to (J) of FIG. 10B.

For example, each of the magnetization states of (A) to (J) of FIG. 10B may correspond to or may be mapped to one level among multiple levels in one-to-one correspondence.

The magnetization state of (A) of FIG. 10B may correspond to 3b'000, the magnetization state of (B) of FIG. 10B may correspond to 3b'001, the magnetization state of (C) of FIG. 10B may correspond to 3b'010, the magnetization state of (D) of FIG. 10B may correspond to 3b'011, the magnetization state of (E) of FIG. 10B may correspond to 3b'100, the magnetization state of (F) of FIG. 10B may correspond to 3b'101, the magnetization state of (G) of FIG. 10B may correspond to 3b'110, and the magnetization state of (H) of FIG. 10B may correspond to 3b'111. However, the magnetization states may be differently defined according to embodiments.

(A) of FIG. 10B may correspond to (A) of FIG. 9, (D) of FIG. 10B may correspond to (B) of FIG. 9, (G) of FIG. 10B may correspond to (C) of FIG. 9, and (J) of FIG. 10B may correspond to (D) of FIG. 9. In detail, (A) of FIG. 9 conceptually illustrates the net magnetization magnitude of (A) of FIG. 10B, (B) of FIG. 9 conceptually illustrates the net magnetization magnitude of (D) of FIG. 10B, (C) of FIG. 9 conceptually illustrates the net magnetization magnitude of (G) of FIG. 10B, and (D) of FIG. 9 conceptually illustrates the net magnetization magnitude of(J) of FIG. 10B.

In light of the first magnetic domain MD1, the net magnetization magnitude of (A) of FIG. 10B may be greater than the net magnetization magnitude of (B) of FIG. 10B. The magnetization direction of (B) of FIG. 10B may be opposite to the magnetization direction of (C) of FIG. 10B, and the magnetization magnitude of (B) of FIG. 10B may be the same as the magnetization magnitude of (C) of FIG. 10B.

The concept illustrated in FIG. 10B may be applied to a method of controlling a magnetization state according to the change in the pulse width of the input pulse current Ix, which will be described with reference to FIG. 11 below, and to a method of controlling a magnetization state according to the change in the pulse amplitude of the input pulse current Ix, which will be described with reference to FIG. 14 below.

FIG. 11 is a conceptual diagram illustrating a method of controlling the magnetization direction of each of the first to third magnetic domains, which are respectively generated according to FIGS. 6 to 8, according to the pulse width of an input current.

Referring to FIGS. 1, 6, 7, 8, and 11, the input current control circuit 130 may control the width of a pulse in the first-direction input current Ix_CD1 or the second-direction input current Ix_CD2 in response to the current control signal CTL. For convenience of description, the first-direction input current Ix_CD1 and the second-direction input current Ix_CD2 are collectively referred to as the input current Ix.

Referring to (A) of FIG. 11, when the input current control circuit 130 supplies the input current Ix at the low-level L to the ferromagnetic memory device 110 in response to the current control signal CTL, the magnetization direction of each of the first to third magnetic domains MD1, MD2, and MD3 may be the first magnetization direction MTD1. As described above with reference to FIG. 9, assuming that the multiple levels include four levels, the first level [00] may be defined or interpreted as 2b'00 among the 2-bit data in a read operation.

Referring to (A) and (B) of FIG. 11, when the input current control circuit 130 supplies the input current Ix having a first pulse width W1 to the ferromagnetic memory device 110 in response to the current control signal CTL, the magnetization direction of only the first magnetic domain MD1 among the first to third magnetic domains MD1, MD2, and MD3 may be changed from the first magnetization direction MTD1 into the second magnetization direction MTD2, and the other magnetic domains, i.e., the second and third magnetic domains MD2 and MD3, may maintain the first magnetization direction MTD1. As described above with reference to FIG. 9, the second level [01] may be defined or interpreted as 2b'01 among the 2-bit data in a read operation.

Referring to (B) and (C) of FIG. 11, when the input current control circuit 130 supplies the input current Ix having a second pulse width W2 to the ferromagnetic memory device 110 in response to the current control signal CTL, the magnetization direction of only the second magnetic domain MD2 among the first to third magnetic domains MD1, MD2, and MD3 may be changed from the first magnetization direction MTD1 into the second magnetization direction MTD2, and the first and third magnetic domains MD1 and MD3 may respectively maintain the second magnetization direction MTD2 and the first magnetization direction MTD1. The second pulse width W2 may be greater than the first pulse width W1.

As described above with reference to FIG. 9, the third level [10] may be defined or interpreted as 2b'10 among the 2-bit data in a read operation.

Referring to (C) and (D) of FIG. 11, when the input current control circuit 130 supplies the input current Ix having a third pulse width W3 to the ferromagnetic memory device 110 in response to the current control signal CTL, the magnetization direction of only the third magnetic domain MD3 among the first to third magnetic domains MD1, MD2, and MD3 may be changed from the first magnetization direction MTD1 into the second magnetization direction MTD2, and each of the first magnetic domain MD1 and the second magnetic domains MD2 may maintain the second magnetization direction MTD2. The third pulse width W3 may be greater than the second pulse width W2.

As described above with reference to FIG. 9, the fourth level [11] may be defined or interpreted as 2b'11 among the 2-bit data in a read operation.

Referring to (E) of FIG. 11, the second level [01] may be higher than the first level [00], the third level [10] may be higher than the second level [01], and the fourth level [11] may be higher than the third level [10].

Although FIG. 11 illustrates an embodiment in which the level increases when the pulse width of one of the first-direction input current Ix_CD1 and the second-direction input current Ix_CD2 increases, the level may decrease when the pulse width of the other one of the first-direction input current Ix_CD1 and the second-direction input current Ix_CD2 increases.

According to embodiments, the magnetization directions of two magnetic domains (e.g., MD1 and MD2, MD2 and MD3, or MD1 and MD3) among the first to third magnetic domains MD1, MD2, and MD3 may be simultaneously switched between the first magnetization direction MTD1 and the second magnetization direction MTD2 according to the change in the pulse width of the input current Ix.

According to embodiments, the magnetization directions of the first to third magnetic domains MD1, MD2, and MD3 may be simultaneously switched between the first magnetization direction MTD1 and the second magnetization direction MTD2 according to the change in the pulse width of the input current Ix.

The magnetization direction of which of the first to third magnetic domains MD1, MD2, and MD3 is to be changed first or the magnetization directions of how many of the first to third magnetic domains MD1, MD2, and MD3 are to be changed simultaneously may be variously changed according to embodiments by using the pulse width of the input current Ix that may vary.

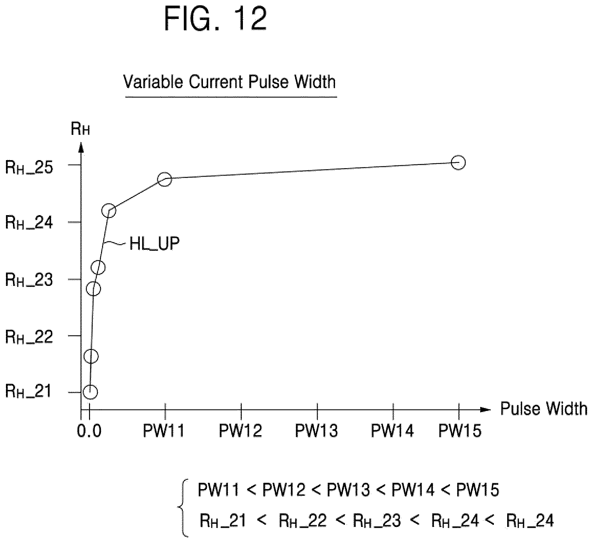

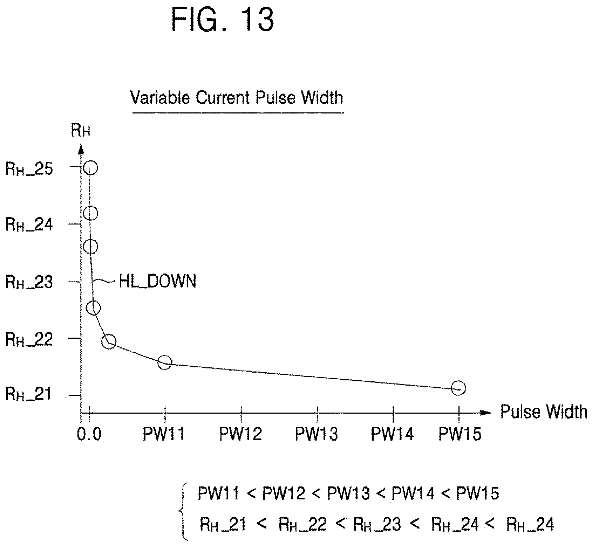

FIG. 12 is a schematic graph illustrating the relationship between the change in the pulse width of an input current and the change of Hall resistance when the input current is a first-direction input current. FIG. 13 is a schematic graph illustrating the relationship between the change in the pulse width of an input current and the change of Hall resistance when the input current is a second-direction input current.

Referring to FIG. 1 and FIGS. 10A to 13, HL_UP in FIG. 12 denotes a schematic graph showing that the Hall resistance R_{H} increases when the pulse width of the first-direction input current Ix_CD1 (=Ix) increases, and HL_DOWN in FIG. 13 denotes a schematic graph showing that the Hall resistance Ru decreases when the pulse width of the second-direction input current Ix_CD2 (=Ix) increases.

FIG. 14 is a conceptual diagram illustrating a method of controlling the magnetization direction of each of the first to third magnetic domains, which are respectively generated according to FIGS. 6 to 8, according to the variation of the amplitude of an input current.

Referring to FIGS. 1, 6, 7, 8, and 14, the input current control circuit 130 may control the amplitude of a pulse in the first-direction input current Ix_CD1 or the second-direction input current Ix_CD2 in response to the current control signal CTL. For convenience of description, the first-direction input current Ix_CD1 and the second-direction input current Ix_CD2 are collectively referred to as the input current Ix.

Referring to (A) of FIG. 14, when the input current control circuit 130 supplies the input current Ix at the low-level L to the ferromagnetic memory device 110 in response to the current control signal CTL, the magnetization direction of each of the first to third magnetic domains MD1, MD2, and MD3 may be the first magnetization direction MTD1. As described above with reference to FIG. 9, assuming that the multiple levels include four levels, the first level [00] may be defined or interpreted as 2b'00 among the 2-bit data in a read operation.

Referring to (A) and (B) of FIG. 14, when the input current control circuit 130 supplies the input current Ix having a first amplitude AT1 to the ferromagnetic memory device 110 in response to the current control signal CTL, the magnetization direction of only the first magnetic domain MD1 among the first to third magnetic domains MD1, MD2, and MD3 may be changed from the first magnetization direction MTD1 into the second magnetization direction MTD2, and the other magnetic domains, i.e., the second and third magnetic domains MD2 and MD3, may maintain the first magnetization direction MTD1. As described above with reference to FIG. 9, the second level [01] may be defined or interpreted as 2b'01 among the 2-bit data in a read operation.

Referring to (B) and (C) of FIG. 14, when the input current control circuit 130 supplies the input current Ix having a second amplitude AT2 to the ferromagnetic memory device 110 in response to the current control signal CTL, the magnetization direction of only the second magnetic domain MD2 among the first to third magnetic domains MD1, MD2, and MD3 may be changed from the first magnetization direction MTD1 into the second magnetization direction MTD2, and the first and third magnetic domains MD1 and MD3 may respectively maintain the second magnetization direction MTD2 and the first magnetization direction MTD1. The second amplitude AT2 may be greater than the first amplitude AT1.

As described above with reference to FIG. 9, the third level [10] may be defined or interpreted as 2b'10 among the 2-bit data in a read operation.

Referring to (C) and (D) of FIG. 14, when the input current control circuit 130 supplies the input current Ix having a third amplitude AT3 to the ferromagnetic memory device 110 in response to the current control signal CTL, the magnetization direction of only the third magnetic domain MD3 among the first to third magnetic domains MD1, MD2, and MD3 may be changed from the first magnetization direction MTD1 into the second magnetization direction MTD2, and each of the first magnetic domain MD1 and the second magnetic domains MD2 may maintain the second magnetization direction MTD2. The third amplitude AT3 may be greater than the second amplitude AT2.

As described above with reference to FIG. 9, the fourth level [11] may be defined or interpreted as 2b'11 among the 2-bit data in a read operation.

Referring to (E) of FIG. 14, the second level [01] may be higher than the first level [00], the third level [10] may be higher than the second level [01], and the fourth level [11] may be higher than the third level [10].

Although FIG. 14 illustrates an embodiment in which the level increases when the amplitude of one of the first-direction input current Ix_CD1 and the second-direction input current Ix_CD2 increases, the level may decrease when the amplitude of the other one of the first-direction input current Ix_CD1 and the second-direction input current Ix_CD2 increases.

According to embodiments, the magnetization directions of two magnetic domains (e.g., MD1 and MD2, MD2 and MD3, or MD1 and MD3) among the first to third magnetic domains MD1, MD2, and MD3 may be simultaneously switched between the first magnetization direction MTD1 and the second magnetization direction MTD2 according to the change in the amplitude of the input current Ix.

According to embodiments, the magnetization directions of the first to third magnetic domains MD1, MD2, and MD3 may be simultaneously switched between the first magnetization direction MTD1 and the second magnetization direction MTD2 according to the change in the amplitude of the input current Ix.

The magnetization direction of which of the first to third magnetic domains MD1, MD2, and MD3 is to be changed first or the magnetization directions of how many of the first to third magnetic domains MD1, MD2, and MD3 are to be changed simultaneously may be variously changed according to embodiments by using the amplitude of the input current Ix that may vary.

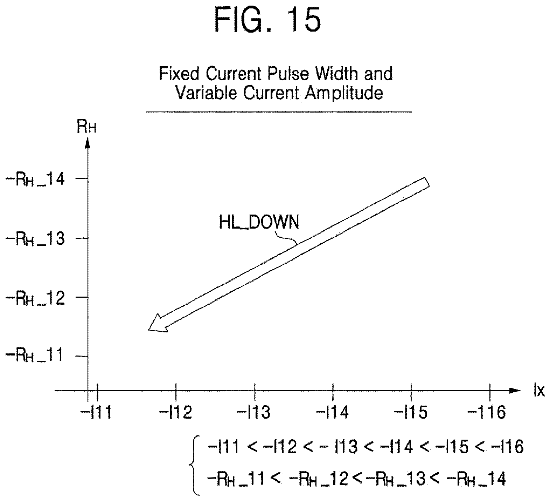

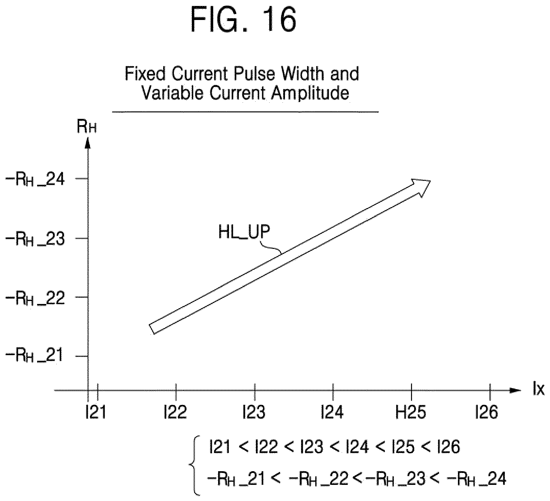

FIG. 15 is a schematic graph illustrating the relationship between the variation of the amplitude of an input current and the change of Hall resistance when the pulse width of the input current is fixed, according to an embodiment of the inventive concept. FIG. 16 is a schematic graph illustrating the relationship between the variation of the amplitude of an input current and the change of Hall resistance when the pulse width of the input current is fixed, according to some embodiments of the inventive concept.

Referring to FIGS. 10A and 10B and FIGS. 14 to 16, HL_DOWN in FIG. 15 denotes a schematic graph showing that the Hall resistance Ru decreases when the second-direction input current Ix_CD2 (=Ix) decreases in the case where the pulses of the second-direction input current Ix_CD2 have the same width.

HL_UP in FIG. 16 denotes a schematic graph showing that the Hall resistance R_{H} increases when the first-direction input current Ix_CD1 (=Ix) increases in the case where the pulses of the first-direction input current Ix_CD1 have the same width.

FIGS. 10, 12, 13, 15, and 16 are schematic graph showing that multiple levels are implemented, without changing the form of the memory cell MC, as a result of changing the Hall resistance R_{H} of the second magnetic layer 103c of the memory cell MC according to a magnetic anisotropy energy gradient formed by magnetic domains e.g., MD1, MD2, and MD3.

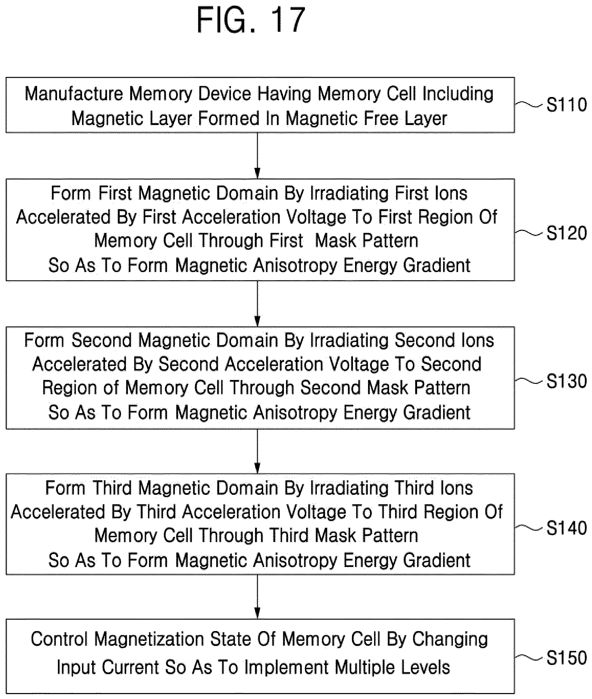

FIG. 17 is a flowchart of a method of manufacturing the ferromagnetic memory device having a magnetic anisotropy energy gradient in FIG. 1 and a method of controlling the movement of magnetization states or magnetic domains of the ferromagnetic memory device by using an input current.

Referring to (B) of FIG. 5 and FIG. 17, a memory device having the memory cell MC including the first to third regions RG1, RG2, and RG3, which are formed in the magnetic free layer and respectively correspond to the first to third magnetic domains MD1, MD2, and MD3, may be manufactured or formed(S110).

Referring to (B) of FIG. 5 and FIGS. 6 and 17, when the first ions 200_IV1 accelerated by a first acceleration voltage are irradiated to the first region RG1 through the first opening OP1 of the first mask pattern MASK1, the first region RG1 may be converted into the first magnetic domain MD1, and a magnetic anisotropy energy gradient may be formed in the memory cell MC including the first magnetic domain MD1(S120).

Referring to (B) of FIG. 5 and FIGS. 7 and 17, when the second ions 200_IV1 accelerated by a second acceleration voltage are irradiated to the second region RG2 through the second opening OP2 of the second mask pattern MASK2, the second region RG2 may be converted into the second magnetic domain MD2, and a magnetic anisotropy energy gradient may be formed in the memory cell MC including the second magnetic domain MD2(S130).

Referring to (B) of FIG. 5 and FIGS. 8 and 17, when the third ions 200_IV1 accelerated by a third acceleration voltage are irradiated to the third region RG3 through the third opening OP3 of the third mask pattern MASK3, the third region RG3 may be converted into the third magnetic domain MD3, and a magnetic anisotropy energy gradient may be formed in the memory cell MC including the third magnetic domain MD3(S140).

After the ferromagnetic memory device 110 having the second magnetic layer 103c including the first to third magnetic domains MD1, MD2, and MD3 corresponding to the magnetic anisotropy energy gradient is formed through operations S110 to S140, the input current control circuit 130 may control the magnetization state of each of the first to third magnetic domains MD1, MD2, and MD3 by controlling the number of pulses in the input current Ix, the pulse width of the input current Ix, or the amplitude of the input current Ix in response to the current control signal CTL, as described above with reference to FIGS. 9, 11, or 14, thereby implementing or defining multiple levels(S150).

The magnetization state of each of the first to third magnetic domains MD1, MD2, and MD3 may define its corresponding level among the multiple levels.

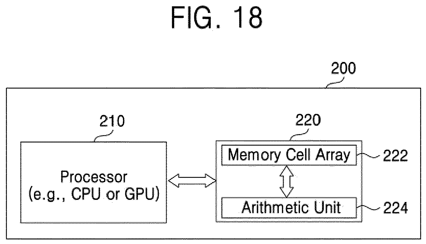

FIG. 18 is a schematic diagram of a PIM including the ferromagnetic memory device having a magnetic anisotropy energy gradient in FIG. 1.

Referring to FIGS. 1 and 18, a PIM 200 may include a processor 210 and a memory device 220. The processor 210 may include a central processing unit (CPU), a graphics processing unit (GPU), or a neural processing unit (NPU). The memory device 220 may include a memory cell array 222 and an arithmetic unit (referred to as an arithmetic unit circuit) 224.

The PIM 200 may be used in an autonomous vehicle, an Internet of things (IoT) device, health informatics, or an SoC.

The ferromagnetic memory device 110 may be used in a domain wall-based magnetic memory.

The memory cell array 222 may include a plurality of ferromagnetic memory devices 110 operating at multiple levels. The arithmetic unit 224 may perform operations using data stored in the memory cell array 222 in the memory device 220 according to a command output from the processor 210 and may transmit only an operation result to the processor 210. Accordingly, the operation capability of the PIM 200 may be increased, and the power consumption of the PIM 200 may be reduced.

According to the inventive concept, unlike spin-transfer torque magnetoresistive random-access memory (STT-MRAM) capable of defining or storing only single-bit data according to the related art, the ferromagnetic memory device 110 capable of defining or storing one of multiple levels may be used in artificial intelligence (AI) for deep learning or the PIM 200 or CIM for intelligent semiconductors.

According to embodiments of the inventive concept, because a ferromagnetic memory device includes a plurality of magnetic domains generated by forming a magnetic anisotropy energy gradient by irradiating or injecting ions into a memory cell of the ferromagnetic memory device, the magnetization state of each of the magnetic domains and/or a magnetization state generated by the interaction between the magnetic domains may be controlled by adjusting the direction, toggling times, pulse width, or amplitude of a current supplied to the ferromagnetic memory device.

The magnetization state of each of the magnetic domains and/or the magnetization state generated by the interaction between the magnetic domains may define each of multiple levels so that the ferromagnetic memory device may store multi-bit data.

## Claims

1. A ferromagnetic memory device comprising a memory cell,
wherein the memory cell includes a magnetic free layer including a magnetic layer, and
wherein the magnetic free layer including a magnetic anisotropy energy gradient induced within the magnetic layer by plasma ion irradiation.

2. The ferromagnetic memory device of claim 1,
wherein the magnetic layer includes a plurality of magnetic domains formed according to the magnetic anisotropy energy gradient induced by the plasma ion irradiation, and
wherein the magnetic anisotropy energy gradient is induced by a magnetization state of each of the plurality of magnetic domains and a magnetization state formed by physical defects including a vacancy and non-uniformity of a chemical state formed inside the each of the plurality of magnetic domains during the plasma ion irradiation.

3. The ferromagnetic memory device of claim 2, wherein the each of the plurality of magnetic domains is formed by injection of ions accelerated by one of different acceleration voltages during the plasma ion irradiation.

4. A semiconductor device comprising a ferromagnetic memory device,
wherein the ferromagnetic memory device includes a memory cell including a plurality of magnetic domains generated in a magnetic free layer,
wherein a magnetic anisotropy energy gradient is induced in the magnetic free layer when ions are injected into the magnetic free layer, and the magnetic domains are formed according to the induced magnetic anisotropy energy gradient.

5. The semiconductor device of claim 4,
wherein a first magnetic domain among the plurality of magnetic domains is generated when first ions accelerated by a first acceleration voltage are injected into a first region among regions of the magnetic free layer, a second magnetic domain among the plurality of magnetic domains is generated when second ions accelerated by a second acceleration voltage are injected into a second region among the regions of the magnetic free layer, and the magnetic anisotropy energy gradient is induced as magnetic anisotropy energy formed by the first ions in the first region is different from magnetic anisotropy energy formed by the second ions in the second region.

6. The semiconductor device of claim 5, wherein the first region includes a first cobalt oxide, the second region includes a second cobalt oxide,
wherein the first magnetic domain includes cobalt reduced from the first cobalt oxide by the first acceleration voltage, and
wherein the second magnetic domain includes cobalt reduced from the second cobalt oxide by the second acceleration voltage.

7. The semiconductor device according to any of claims 4 to 6, further comprising a current control circuit configured to induce a greater number of different magnetization states than a number of the magnetic domains by supplying a current pulse to the ferromagnetic memory device.

8. The semiconductor device of claim 7, wherein the magnetization states include:
a magnetization state of each of the magnetic domains; and
magnetic states formed by physical defects including a vacancy and non-uniformity of a chemical state formed inside the magnetic domains.

9. The semiconductor device of claim 7 or 8, wherein each of the magnetization states defines its corresponding level among multiple levels including different levels.

10. The semiconductor device according to any of claims 7 to 9, wherein each of the magnetization states is determined depending on a direction of the current pulse, a number of toggling times of the current pulse, a width of the current pulse, or an amplitude of the current pulse.

11. The semiconductor device according to any of claims 4 to 10, wherein the semiconductor device corresponds to a process-in-memory or a computing-in-memory.

12. A method of manufacturing a ferromagnetic memory device, the method comprising:
providing a memory device having a memory cell including a magnetic free layer having a magnetic layer; and
forming a magnetic anisotropy energy gradient within the memory cell.

13. The method of claim 12, wherein the forming of the magnetic anisotropy energy gradient includes forming the magnetic anisotropy energy gradient by injecting ions into the memory cell.

14. The method of claim 12 or 13, wherein the forming of the magnetic anisotropy energy gradient includes forming the magnetic anisotropy energy gradient by generating ferromagnetic regions in the magnetic layer by injecting ions into regions of the magnetic layer by using different mask patterns, respectively, at different time points, the ions being accelerated by acceleration voltages respectively corresponding to the regions of the magnetic layer.

15. The method according to any of claims 12 to 14, wherein each of the regions of the magnetic layer includes a cobalt oxide, each of the ferromagnetic regions include cobalt reduced from the cobalt oxide by the ions, and the ferromagnetic regions have different magnetic anisotropy energy as the ions accelerated by the different acceleration voltages respectively corresponding to the regions of the magnetic layer are injected into the regions of the magnetic layer.
